# DEMANDE DE BREVET EUROPEEN

(11) **EP 0 753 894 A1**
(43) Date de publication de la demande: **15.01.1997**
(21) Numéro de dépôt: 96401520.0
(22) Date de dépôt: 10.07.1996
(51) Int. Cl.: H01L 39/14

(54) **Supraconducteur multi-brins à barrière résistive intégrée**

(30) Priorité: 13.07.1995 FR 9508571
(71) Demandeur: GEC ALSTHOM ELECTROMECANIQUE SA, 75116 Paris (FR)
(72) Inventeur: Sulten, Philippe, 90350 Evette-Salvert (FR); Bruzek, Christian Eric, 90000 Belfort (FR); Hoang, Giaky, 90300 Cravanche (FR)
(74) Mandataire: Fournier, Michel

(57) **Abrégé**

L'invention concerne un brin supraconducteur comprenant, en coupe transversale, une zone centrale (2) constituée dune pluralité de filaments supraconducteur (3) de type NbTi, NbTiTa ou tout autre alliage ou composé à base de Nb, une couronne extérieure concentrique (4) entourant ladite zone centrale (2), et une barrière concentrique résistive (5), selon l'invention, ladite barrière concentrique résistive (5) est intégrée dans la couronne extérieure concentrique (4).

## Description

L'invention concerne un brin supraconducteur multifilamentaire à barrière résistive intégrée dans la couronne extérieure, un câble constitué d'un tel brin, et un procédé de fabrication d'un tel brin.

Plus particulièrement la présente invention concerne :
un brin supraconducteur multifilamentaire comprenant, en coupe transversale, une zone centrale constituée dune pluralité de filaments supraconducteur, une couronne extérieure concentrique entourant ladite zone centrale, et une barrière concentrique résistive ;
un câble constitué d'un tel brin ; et
un procédé de fabrication d'un tel brin.

La barrière résistive est destinée à limiter les couplages électriques entre les filaments supraconducteurs d'un brin et entre les brins à filaments supraconducteurs assemblés en câble. Ces couplages électriques induisent des pertes par effet Joule, qui se traduisent par un échauffement des brins du câble et donc par une augmentation de la consommation cryogénique.

Il est donc important de pourvoir les brins de barrières résistives limitant sensiblement le couplage et donc l'échauffement dans le câble. On limite ainsi la consommation cryogénique et donc les coûts d'exploitation de la machine utilisant ces câbles supraconducteurs.

Un brin supraconducteur multifilamentaire est fabriqué selon de nombreux procédé connus. On connaît notamment les procédés multi-étages de filage et de mise en billette d'un barreau de matériau supraconducteur entouré de cuivre.

Pour cela on file une première fois le barreau composite, puis on remplit un cylindre creux en cuivre avec des tiges de barreau composite filé, puis on ferme le cylindre et on y fait le vide, enfin on file la billette ainsi obtenue réalisant ainsi un multi-filaments. Dans les étages suivants on répète avec le multi-filaments les mêmes opérations que sur le barreau composite filé.

Une fois que l'on obtient un multi-filaments contenant le nombre de filaments voulu pour remplir la billette de l'étage final, ce dernier consiste à mettre le brin à la dimension voulue.

Pour cela on charge un cylindre creux constitué du matériau de la couronne extérieure (par exemple le cuivre) avec des tiges de multi-filaments, puis on ferme le cylindre et on y fait le vide, enfin on file la billette ainsi obtenue jusqu'à la dimension voulue du brin supraconducteur à couronne extérieure.

Dans une autre phase on dépose autour du brin obtenu une couche externe de Cr ou de Ni ou de Sn ou tout autre métal pouvant constituer la barrière résistive du brin.

Ce dépôt est notamment effectué par une trempe du brin ou par un dépôt électrolytique.

De tels procédés ont des inconvénients :

Des inconvénients d'ordre spatial puisqu'ils imposent un atelier supplémentaire spécifiquement dédié à la réalisation de la barrière résistive.

Des inconvénients liés au prix de revient, induits d'une part, du fait de l'existence de cet atelier supplémentaire, et, d'autre part, du fait du coût substantiel des matériaux constituant lesdites barrières.

Des inconvénients d'ordre technique, lors du dépôt de la barrière résistive. En effet, l'épaisseur de la barrière résistive a une limite en dessous de laquelle elle présente des défauts de recouvrement (absence de matière, ou barrière fragilisée).

En outre de telles barrières réduisent les pertes inter-brins, mais n'ont que peu d'effet sur les pertes intra-filamentaires au sein d'un même brin.

Un des buts de la présente invention est de proposé un brin supraconducteur mulifilamentaire ayant une barrière intégrée dans la couronne extérieure. La position de la barrière dans la couronne extérieure, son épaisseur, et sa nature, permettent d'ajuster le niveau des pertes intra-filamentaire et le niveau des pertes inter-brin, et d'arriver à un compromis optimal sur les pertes totales. En outre, la barrière, par son épaisseur, et sa nature, permet de faire varier le Rapport de Résistance Résiduelle (RRR) de la couronne extérieure.

Un autre but de la présente invention est de proposer un brin supraconducteur multifilamentaire à barrière résistive ne nécessitant pas d'atelier supplémentaire différent des ateliers de filage classique.

Un autre but de la présente invention est de proposer un brin supraconducteur multifilamentaire ayant une barrière résistive dont l'épaisseur n'est pas limitée.

Un autre but de la présente invention est de proposer un procédé de fabrication d'un brin supraconducteur multifilamentaire à barrière résistive économique par rapport à l'art antérieur.

A cet effet l'invention concerne un brin supraconducteur comprenant, en coupe transversale, une zone centrale constituée dune pluralité de filaments supraconducteur de type NbTi, NbTiTa ou tout autre alliage ou composé à base de Nb, une couronne extérieure concentrique entourant ladite zone centrale, et une barrière concentrique résistive. Selon l'invention ladite barrière concentrique résistive est intégrée dans la couronne extérieure concentrique en cuivre.

Dans une forme de réalisation, la barrière concentrique résistive est en cupronickel, cupromanganèse, ou tout autre métal résistif compatible avec la nature de la couronne extérieure.

L'invention concerne aussi un câble supraconducteur comprenant une pluralité de brins supraconducteurs tels que décrits ci-dessus tressés ou torsadés ensemble.

Les brins supraconducteurs tressés ou torsadés ensembles forment un câble muti-brins transposé.

L'invention concerne enfin un procédé de fabrication dun brin supraconducteur à couronne extérieure de cuivre à N étages de filage, comprenant N-1 étages de mise en billette et filage successifs pour la fabrication dun multi-filaments Du type NbTi ou NbTiTa ou tout autre alliage ou composé à base de Nb.

Pour cela on file une première fois un barreau composite comprenant une barre de NbTi ou NbTiTa ou tout autre alliage ou composé à base de Nb entourée de cuivre, puis on remplit un cylindre creux en cuivre avec des tiges de barreau composite filé, puis on ferme le cylindre et on y fait le vide, enfin on file la billette ainsi obtenue réalisant ainsi un multi-filaments. Dans les étages suivants on répète avec le multi-filaments les mêmes opérations que sur le barreau composite filé.

Selon l'invention, le procédé comprend un étage N final qui sera mis à dimension finale du brin dans lequel :
on dispose coaxialement un cylindre creux distal façonné dans le matériau de la couronne extérieure, un cylindre creux intermédiaire façonné dans le matériau de la barrière résistive, et un cylindre creux proximal façonné dans le matériau de la couronne extérieure, constituant ainsi un cylindre creux composite;
on comble le creux dudit cylindre creux composite en agençant de façon ordonnée des tiges du multi-filaments résultant de létage N-1 du procédé; réalisant ainsi une billette;
on ferme les extrémités de la billette et on opère une mise sous vide de l'intérieur de la billette;
on opère un filage de la billette jusquau diamètre voulu du brin supraconducteur.

Les épaisseurs des cylindres creux sont choisis pour que, une fois filé, le brin présente une barrière résistive ayant une épaisseur et une localisation dans la couronne extérieure prédéterminées.

Le choix des épaisseurs est fonction d'un rapport prédéterminé entre les pertes inter-brins et les pertes intra-filamentaire.

Le choix des épaisseurs peut être aussi fonction d'un Rapport de Résistance Résiduelle (RRR) prédéterminé.

Un avantage de la présente invention résulte du fait que pour la fabrication de la barrière résistive des brins selon l'invention on peut utiliser les ateliers de filage du multi-filaments.

Un autre avantage de la présente invention résulte du fait que l'épaisseur de la barrière résistive est mieux contrôlée que dans l'art antérieur, cette épaisseur peut être inférieure à la limite des barrières de l'art antérieur.

Un autre avantage de la présente invention résulte de l'utilisation de cupronickel, de cupromanganèse, ou tout autre métaux résistif compatible avec la nature de la couronne extérieure comme matériau de la barrière résistive. En effet ces matériaux sont bien meilleur marché que le Chrome ou le Nickel utilisé dans l'art antérieur.

D'autres avantages et caractéristiques de la présente invention résulteront de la description qui va suivre en référence aux dessins annexés dans lesquels :

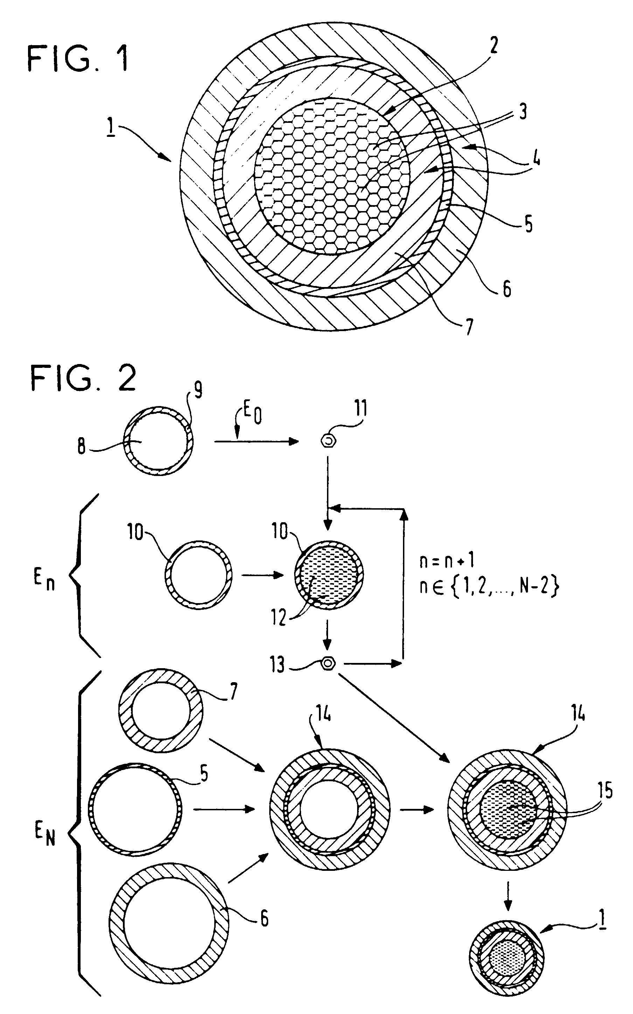

La figure 1 est une représentation schématique en coupe transversale d'un brin supraconducteur multifilamentaire à barrière résistive intégrée dans la couronne extérieure selon l'invention.

La figure 2 est un diagramme schématique des étapes du procédé de fabrication d'un brin supraconducteur multifilamentaire à barrière résistive intégrée dans la couronne extérieure selon l'invention.

L'invention concerne un brin supraconducteur 1 comprenant, en coupe transversale, une zone centrale 2 constituée dune pluralité de filaments supraconducteurs 3 de type NbTi, NbTiTa ou tout autre alliage ou composé à base de Nb, une couronne extérieure concentrique 4 entourant ladite zone centrale, et une barrière concentrique résistive 5.

Selon l'invention la couronne extérieure concentrique 4 comprend une couronne distale 6, et une couronne proximale 7 entre lesquelles est intercalée la barrière concentrique résistive 5.

Ainsi, selon l'invention, la barrière concentrique résistive 5 est intégrée dans la couronne extérieure concentrique 4 en cuivre.

Avantageusement la barrière concentrique résistive 5 est en cupronickel, cupromanganèse, ou tout autre métal résistif compatible avec la nature de la couronne extérieure 4.

L'invention concerne aussi un câble supraconducteur (non représenté) comprenant une pluralité de brins supraconducteurs 1 tressés ou torsadés ensembles.

Avantageusement les brins supraconducteurs 1 tressés ou torsadés ensembles forment un câble multi-brins transposé.

Enfin l'invention concerne un procédé de fabrication dun brin supraconducteur 1 à couronne extérieure de cuivre 4 à N étages de filage, comprenant N-1 étages de mise en billette et filage successifs pour la fabrication du multi-filaments 3 Du type NbTi ou NbTiTa ou tout autre alliage ou composé à base de Nb, et un étage N de mise à dimension du brin.

Durant les N-1 étages :
on file une première fois (E₀) un barreau composite comprenant une barre 8 de NbTi ou NbTiTa ou tout autre alliage ou composé à base de Nb entourée de cuivre 9, puis (E₁) on remplit un cylindre creux 10 en cuivre avec des tiges 12 de barreau composite filé 11, puis on ferme le cylindre et on y fait le vide, enfin on file la billette ainsi obtenue réalisant ainsi un multi-filaments 13. Dans un étage Eₙ avec n variant de 2 à N-1, on répète avec le multi-filaments obtenu à l'étage Eₙ₋₁ les mêmes opérations que dans l'étage E₁.

Dans l'étage N :
on dispose coaxialement un cylindre creux distal 6 façonné dans le matériau de la couronne extérieure, un cylindre creux intermédiaire 5 façonné dans le matériau de la barrière résistive, et un cylindre creux proximal 7 façonné dans le matériau de la couronne extérieure, constituant ainsi un cylindre creux composite 14;
on comble le creux dudit cylindre creux composite 14 en agençant de façon ordonnée des tiges 15 du multi-filaments 13 résultant de létage N-1 du procédé; réalisant ainsi une billette;
on ferme les extrémités de la billette et on opère une mise sous vide de l'intérieur de la billette;
on opère un filage de la billette jusquau diamètre voulu du brin supraconducteur 1.

Avantageusement les multi-filaments sont filés dans une filière ayant une forme appropriée pour faciliter le remplissage des billettes. Notamment la forme peut avoir une coupe transversale hexagonale pour faciliter le remplissage des billettes.

Selon le procédé les épaisseurs des cylindres creux 5, 6, 7 sont choisis pour que, une fois filé, le brin 1 présente une barrière résistive ayant une épaisseur et une localisation dans la couronne extérieure 4 prédéterminées.

Avantageusement, on choisit les épaisseurs des cylindres creux 5, 6, 7 et le matériau de la barrière résistive pour obtenir un rapport prédéterminé entre les pertes inter-brins et les pertes intra-filamentaire.

Avantageusement on choisit les épaisseurs des cylindres creux 5, 6, 7 et le matériau de la barrière résistive pour obtenir un Rapport de Résistance Résiduelle (RRR) prédéterminé.

Bien entendu, l'invention n'est pas limitée aux modes de réalisation décrits et représentés, mais elle est susceptible de nombreuses variantes accessibles à l'homme du métier sans que l'on s'écarte de l'invention. Notamment tous les procédés connus de fabrication de multi-filaments supraconducteurs sont utilisables sans sortir du domaine de la présente invention.

## Revendications

1. Câble supraconducteur comprenant une pluralité de brins supraconducteurs (1), caractérisé en ce que chaque brin supraconducteur comprend, en coupe transversale, une zone centrale (2) constituée d'une pluralité de filaments supraconducteurs (3) de type NbTi, NbTiTa ou tout autre alliage ou composé à base de Nb, une couronne extérieure concentrique (4) entourant ladite zone centrale (2), et une barrière concentrique résistive (5), ladite barrière concentrique résistive (5) étant intégrée dans la couronne extérieure concentrique (4).

2. Câble supraconducteur selon la revendication 1 caractérisé en ce que la barrière concentrique résistive (5) des brins supraconducteur (1) est en cupronickel, cupromanganèse, ou tout autre métal ou alliage résistif compatible avec la nature de la couronne extérieure (4).

3. Câble supraconducteur selon la revendication 1 ou 2 caractérisé en ce que les brins supraconducteurs (1) sont tressés ou torsadés ensemble.

4. Câble supraconducteur selon la revendication 3 caractérisé en ce que les brins supraconducteurs (1) tressés ou torsadés ensembles forment un câble multi-brins transposé.

5. Procédé de fabrication d'un brin supraconducteur (1) à couronne extérieure de cuivre (4) à N étages de filage, comprenant N-1 étages de mise en billette et filage successifs pour la fabrication d'un multi-filaments Du type NbTi ou NbTiTa ou tout autre alliage ou composé à base de Nb, caractérisé en ce que pour l'étage N de mise à dimension du brin,
on dispose coaxialement un cylindre creux distal (6) façonné dans le matériau de la couronne extérieure, un cylindre creux intermédiaire (5) façonné dans le matériau de la barrière résistive, et un cylindre creux proximal (7) façonné dans le matériau de la couronne extérieure, constituant ainsi un cylindre creux composite (14);
on comble le creux dudit cylindre creux composite (14) en agençant de façon ordonnée des tiges (15) du multi-filaments (13) résultant de l'étage N-1 du procédé; réalisant ainsi une billette;
on ferme les extrémités de la billette et on opère une mise sous vide de l'intérieur de la billette;
on opère un filage de la billette jusqu'au diamètre voulu du brin supraconducteur (1).

6. Procédé selon la revendication 5 caractérisé en ce que les épaisseurs des cylindres creux (5, 6, 7) sont choisis pour que, une fois filé, le brin (1) présente une barrière résistive ayant une épaisseur et une localisation dans la couronne extérieure (4) prédéterminées.

7. Procédé selon la revendication 5 ou 6 caractérisé en ce que l'on choisit les épaisseurs des cylindres creux (5, 6, 7) et le matériau de la barrière résistive pour obtenir un rapport prédéterminé entre les pertes inter-brins et les pertes intra-filamentaire.

8. Procédé selon l'une quelconque des revendications 5 à 7 caractérisé en ce que l'on choisit les épaisseurs des cylindres creux (5, 6, 7) et le matériau de la barrière résistive pour obtenir un Rapport de Résistance Résiduelle (RRR) prédéterminé.
